# EUROPÄISCHE PATENTANMELDUNG

(11) **EP 1 065 682 A2**
(43) Veröffentlichungstag der Anmeldung: **03.01.2001**
(21) Anmeldenummer: 00112232.4
(22) Anmeldetag: 07.06.2000
(51) Int. Cl.: H01G 9/20

(54) **Photoelektrochemische Zelle und Verfahren zum Herstellung einer Gegenelektrode für eine photoelektrochemische Zelle**

(30) Priorität: 29.06.1999 DE 19929509
(71) Anmelder: Institut für Angewandte Photovoltaik, 45886 Gelsenkirchen (DE)
(72) Erfinder: Holzbock, Jürgen, Dr., 45881 Gelsenkirchen (DE); Knebel, Olaf, Dipl.-Chem., 44399 Dortmund (DE); Uhlendorf, Ingo, Dr., 45881 Gelsenkirchen (DE)
(74) Vertreter: Tönhardt, Marion, Dr.

(57) **Zusammenfassung**

Eine photoelektrochemische Zelle mit einer Arbeitselektrode und einer gegenüber der Arbeitselektrode angeordneten Gegenelektrode, deren elektrochemisch aktive Oberflächen einander zugewandt sind und wobei zwischen den Oberflächen ein Elektrolyt vorgesehen ist, der ein Redoxsystem enthält, wobei die Oberfläche der Gegenelektrode katalytisch aktiv ist, ist dadurch gekennzeichnet, daß die katalytisch aktive Oberfläche der Gegenelektrode wenigstens ein Polymer und/oder wenigstens ein Salz eines Polymers aufweist, das durch das Redoxsystem des Elektrolyten zu einem intrinsisch elektrisch leitfähigen Polymer dotiert ist.

## Beschreibung

Die Erfindung betrifft eine photoelektrochemische Zelle, mit einer Arbeitselektrode und einer gegenüber der Arbeitselektrode angeordneten Gegenelektrode, deren elektrochemisch aktive Oberflächen einander zugewandt sind, wobei zwischen den Oberflächen ein Elektrolyt vorgesehen ist, der ein Redoxsystem enthält, wobei die Oberfläche der Gegenelektrode katalytisch aktiv ist. Die Erfindung betrifft auch ein Verfahren zum Herstellen einer Gegenelektrode für eine photoelektrochemische Zelle.

Eine photoelektrochemische Zelle ähnlich der Art, wie sie eingangs beschrieben ist, ist beispielsweise in der EP 0 333 641 B1 offenbart. Die Arbeitselektrode umfaßt dort einen polykristallinen Metalloxid-Halbleiter mit einer Chromophor-Schicht als elektrisch aktiver Oberfläche. Als Metalloxid-Halbleiter wird bevorzugt Titanoxid eingesetzt, das auf einer mit einer leitfähigen Schicht überzogenen Glasplatte aufgetragen ist. Als Gegenelektrode wird für derartige photoelektrochemische Zellen ebenfalls ein leitfähiges beschichtetes Glas benutzt, auf dessen Oberfläche ein katalytisch aktives Material aufgetragen ist. Die WO97/12382 schlägt dazu vor, Platin zu verwenden.

Ein weiterer Aufbau einer photoelektrochemischen Zelle, bei der als Gegenelektrode eine Kohlenstoffschicht eingesetzt wird, ist in der DE 195 40 712 A1 beschrieben. Diese muß, damit hinreichende Ströme fließen können, in der Regel sehr dick gehalten sein. Da die katalytische Aktivität des Kohlenstoffes gering ist, muß sie eine hohe Oberfläche haben oder katalytisch aktiviert werden.

Die Gegenelektrode ist ein wesentlicher Bestandteil der photoelektrochemischen Zelle. Die Hauptanforderung an das katalytisch aktive Material besteht darin, daß die Elektronenübertragung in den Elektrolyten mit möglichst geringer kinetischer Hemmung ablaufen muß, das heißt, die Austauschstromdichte I₀ für den Prozeß muß möglichst hoch sein.

Ein Strom in einer photoelektrochemischen Zelle, wie sie oben beschrieben ist, kommt dadurch zustande, daß ein auf dem porösen Halbleiter adsorbierter Farbstoff nach Anregung durch Lichtenergie Elektronen in den Halbleiter injiziert. Die Elektronen gelangen dabei über die leitende Substratbeschichtung in den äußeren Stromkreis und können dort Arbeit verrichten. Der oxidierte Farbstoff wird durch Elektronen aus dem Elektrolyten reduziert, der die gesamte Zelle bis hin zur Gegenelektrode ausfüllt. Der Elektrolyt enthält üblicherweise ein Redoxsystem, beispielsweise Jod/Jodid, Brom/Bromid oder andere Systeme, wie sie beispielsweise in der EP 0 333 641 B1 beschrieben sind.

Um den Stromkreis in der photoelektrochemischen Zelle zu schließen, müssen die aus dem äußeren Stromkreis ankommenden Elektronen an der Gegenelektrode wieder in den Elektrolyten übertragen werden. Das katalytisch aktive Material der Gegenelektrode erleichtert diesen Prozeß.

Das in der WO97/12382 genannte Platin als katalytisch aktive Substanz hat allerdings den Nachteil, daß es eine relativ teure Komponente der Zelle darstellt. Die WO97/12382 stellt die Kombination von Platin mit einem Jod/Jodid-Elektrolyten in den Vordergrund. Es ist nun gefunden worden, daß das Platin sich über eine Reaktion mit dem Jod auflöst, wobei die Reaktion zwar sehr langsam läuft, jedoch in jedem Fall die Lebensdauer der Zelle frühzeitig beendet. Es werden daher nach Alternativen für diesen Katalysator gesucht, wobei die oben beschriebenen Kohlenstoffschichten der DE 195 40 712 A1 nicht als optimal angesehen werden.

Es ist die Aufgabe der Erfindung, eine photoelektrochemische Zelle mit einer katalytisch aktiven Gegenelektrode bereitzustellen, die auf teure Materialien verzichtet und nichtsdestotrotz eine hohe Effektivität zeigt.

Diese Aufgabe wird durch eine photoelektrochemische Zelle nach Anspruch 1 gelöst. Ein Verfahren zum Herstellen einer Gegenelektrode für eine solche photoelektrochemische Zelle ist Gegenstand des Anspruchs 7.

Erfindungsgemäß ist vorgesehen, daß die katalytisch aktive Oberfläche der Gegenelektrode wenigstens ein Polymer und/oder wenigstens ein Salz eines Polymers mit einer Folge von aromatischen Ringen in der Hauptkette aufweist.

Die katalytische Aktivität wird dabei im Hinblick auf das verwendete Redoxsystem beurteilt.

Es ist gefunden worden, daß diese katalytisch aktiven Polymere langzeitstabil sind und durch übliche Arbeitstechniken aufgebracht werden können. Weiter ist zum Erzielen der katalytischen Aktivität kein Temperschritt erforderlich, wie er für Platin regelmäßig durchzuführen ist.

Bevorzugt ist das Polymer eines auf der Basis von Polyanilin, Polypyrrol oder Polythiophen.

Besonders bevorzugt enthält die katalytisch aktive Oberfläche Polyethylendioxythiophen oder besteht vollständig daraus.

Das katalytisch aktive Polymer und/oder das Polymersalz können Graphitpulver und/oder Ruß beigemischt werden. Eine leitfähige Schicht kann dann gemeinsam mit dem Katalysator vorliegen, d.h. die Kohlenstoffschichten werden selbst katalytisch aktiviert und dienen ihrerseits als leitfähige Schicht.

Es kann auch vorgesehen sein, daß das katalytisch aktive Polymer und/oder sein Salz in Mischung mit mindestens einem elektrisch nicht leitenden Polymer oder Polymersalz vorliegt. Dieses elektrisch nicht leitende Polymer kann eines auf der Basis von Styrol sein, beispielsweise Polystyrolsulfonat.

Die erfindungsgemäßen photoelektrochemischen Zellen können zu Modulen verschaltet werden. Die Gegenelektrode und eine benachbarte Arbeitselektrode werden durch ein Verschaltungselement verbunden. Dieses Verschaltungselement kann auch aus einer Mischung von Kohlenstoff mit den katalytisch aktiven Polymeren bzw. Polymersalzen bestehen.

Ein Verfahren zum Herstellen einer Gegenelektrode für eine photoelektrochemische Zelle umfaßt die Schritte:
- Bereitstellen eines Substrates und
- Aufbringen einer Beschichtung aus wenigstens einem Polymer und/oder einem Salz eines Polymers mit einer Folge von aromatischen Ringen in der Hauptkette auf das Substrat durch elektrochemische Abscheidung, Aufsprühen, Aufdrucken, Eintauchen des Substrats in eine das Polymer oder seine Salze oder die entsprechenden Monomere enthaltenden Lösung oder Suspension oder direkte Polymerisation auf dem Substrat.

Ausgangssubstanz für eine katalytisch aktive Beschichtung mit Polyethylendioxythiophen, das für ein Jod/Jodid-Redoxsystem besonders geeignet ist, kann beispielsweise 3,4-Ethylendioxythiophen sein, das unter dem Namen Baytron M von der Bayer AG vertrieben wird.

Soll die photoelektrochemische Zelle eine getrennte elektrisch leitende Schicht enthalten, wird diese zunächst aufgebracht und anschließend die katalytisch aktive Beschichtung auf die elektrisch leitende Schicht aufgebracht. Auf die oben bereits angesprochene Alternative des Einmischens in Graphitpulver und/oder Ruß wird verwiesen.

Zumindest für die katalytisch aktive Beschichtung wird bevorzugt ein Haftvermittler, beispielsweise Silan, verwendet.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Photoelektrochemische Zelle, mit
- einer Arbeitselektrode und
- einer gegenüber der Arbeitselektrode angeordneten Gegenelektrode, deren elektrochemisch aktive Oberflächen einander zugewandt sind und wobei zwischen den Oberflächen ein Elektrolyt vorgesehen ist, der ein Redoxsystem enthält, wobei die Oberfläche der Gegenelektrode katalytisch aktiv ist,
dadurch gekennzeichnet, daß die katalytisch aktive Oberfläche der Gegenelektrode wenigstens ein Polymer und/oder wenigstens ein Salz eines Polymers mit einer Folge von aromatischen Ringen in der Hauptkette aufweist.

2. Photoelektrochemische Zelle nach Anspruch 1, dadurch gekennzeichnet, daß das Polymer eines auf Basis von Polyanilin, Polypyrrol oder Polythiophen ist.

3. Photoelektrochemische Zelle nach Anspruch 2, dadurch gekennzeichnet, daß die katalytisch aktive Oberfläche Polyethylendioxythiophen aufweist.

4. Photoelektrochemische Zelle nach einem der Ansprüche 1 bis 3, dadurch gekennzeichnet, daß das Polymer und/oder sein Salz in Mischung mit Graphitpulver und/oder Ruß vorliegt.

5. Photoelektrochemische Zelle nach einem der Ansprüche 1 bis 4, dadurch gekennzeichnet, daß das Polymer und/oder sein Salz in Mischung mit mindestens einem elektrisch nicht leitenden Polymer oder Polymersalz vorliegt.

6. Photoelektrochemische Zelle nach Anspruch 5, dadurch gekennzeichnet, daß das elektrisch nicht leitende Polymer eines auf der Basis von Styrol ist.

7. Verfahren zum Herstellen einer Gegenelektrode für eine photoelektrochemische Zelle nach einem der Ansprüche 1 bis 6, mit den Schritten:
- Bereitstellen eines Substrates und
- Aufbringen einer Beschichtung aus wenigstens einem Polymer und/oder einem Salz eines Polymers mit einer Folge von aromatischen Ringen in der Hauptkette, auf das Substrat durch elektrochemische Abscheidung, Aufsprühen, Aufdrucken, Eintauchen des Substrates in eine das Polymer oder seine Salze oder die entsprechenden Monomere enthaltende Lösung oder Suspension oder direkte Polymerisation auf dem Substrat.

8. Verfahren nach Anspruch 7, gekennzeichnet durch das Aufbringen einer elektrisch leitenden Schicht auf das Substrat und anschließendes Aufbringen der Beschichtung auf die elektrisch leitende Schicht.

9. Verfahren nach Anspruch 7 oder 8, dadurch gekennzeichnet, daß zumindest für die Beschichtung ein Haftvermittler verwendet wird.
